# FASCICULE DE BREVET EUROPEEN

(11) **EP 0 866 507 B1**
(45) Date de publication et mention de la délivrance du brevet: **09.10.2002**
(21) Numéro de dépôt: 98400609.8
(22) Date de dépôt: 16.03.1998
(51) Int. Cl.: H01L 39/14

(54) **Procédé de découplage d'un brin multifilamentaire supraconducteur Htc à matrice à base d'argent, et brin multifilamentaire ainsi réalisé**
Verfahren zur Entkopplung von mit Silber bedeckten Fasern in einem Htc supraleitenden Verbundleiter und eine solche Verbundleiter
Method for decoupling a silver sheathed filament in a multifilament Htc superconductor wire and such a multifilament wire

(30) Priorité: 20.03.1997 FR 9703416
(43) Date de publication de la demande: 23.09.1998
(73) Titulaire: Nexans, 75008 Paris (FR)
(72) Inventeur: Leriche, Albert, 91190 Gif sur Yvette (FR); Beghin, Erick, 92100 Boulogne (FR); Duperray, Gérard, 91290 La Norville (FR); Legat, Denis, 91090 Lisses (FR); Herrmann, Peter Friedrich, 91410 Corbeuse (FR)
(74) Mandataire: Feray, Valérie

(56) Documents cités:
- EP-A- 0 358 779
- EP-A- 0 412 527
- WO-A-96/28853

## Description

L'invention concerne un brin supraconducteur multifilamentaire à Haute Température critique (HTc) et un procédé de fabrication d'un tel brin. Plus particulièrement l'invention concerne un brin supraconducteur HTc multifilamentaire à gainage d'Argent utilisé en courant alternatif, et un procédé de fabrication d'un tel brin.

L'utilisation en courant alternatif des brins supraconducteurs multifilamentaires HTc implique un bon découplage des filaments supraconducteurs HTc constitutifs afin de limiter les pertes énergétiques par les courants induits.

Il est connu de réaliser des brins multifilamentaires HTc par la technologie "Poudre En Tube" (Powder In Tube). Cela consiste à remplir une billette de réactifs poudreux susceptibles, après traitement thermique, de se transformer en matériau supraconducteur notamment du type céramique HTc.

Cette billette est ensuite fermée sous vide et étirée, mise en faisceau dans une nouvelle billette elle-même fermée sous vide et étirée à son tour. Le brin multifilamentaire résultant peut subir les mêmes étapes, et ainsi de suite jusqu'au nombre de filaments par unité de surface voulu.

Le brin ainsi réalisé est alors mis en forme définitive par exemple par laminage et/ou torsadage, puis traité thermiquement pour la transformation des réactifs poudreux.

On sait que le matériau constitutif des billettes doit être suffisamment ductile pour pouvoir subir les différentes phases d'étirages et de laminage, et avoir une composition inerte ou du moins sans conséquences pour le traitement thermique de transformation des réactifs poudreux en phase supraconductrice. Il est connu d'utiliser l'Argent comme matériau constitutif des billettes.

Cependant, l'Argent est un matériau très conducteur aux températures de fonctionnement des supraconducteurs HTc. De ce fait le découplage électrique entre filament est quasiment inexistant.

Il est connu de doper l'Ag avec des impuretés du type Pd ou Au à 1 ou 2 %. Cette technique permet de gagner 2 décades de résistivité à 20 K.

Cette technique permet aussi des applications à 77 K. Cependant l'alliage Ag/Pd est coûteux ce qui le rend économiquement rédhibitoire dans des applications de grande série.

Il est aussi connu, outre l'augmentation de résistivité de la matrice à base d'Argent, de torsader le conducteur avec un pas très petit, et avec un diamètre de filament très faible. Cependant, le découplage résultant n'est pas suffisant pour la majeure partie des applications en courant alternatif.

WO-A-9628853 décrit un brin multifilamentaire supraconducteur HTc ayant en coupe transversale une forme générale rectangulaire, comprenant une pluralité de filaments supraconducteurs. Chaque filament supraconducteur a en coupe transversale une forme générale rectangulaire et comprend un coeur en céramique supraconductrice HTc, ledit coeur étant entouré par une gaine d'Ag. Le brin est fait de manière que chaque filament supraconducteur est entouré par une couche d'isolant électrique couvrant toutes les faces de la gaine d'Ag.

L'un des buts de la présente invention est de proposer un brin multifilamentaire dont le découplage des filaments est sensiblement amélioré.

A cet effet l'invention concerne un procédé de fabrication du type poudre en tube d'un brin multifilamentaire supraconducteur HTc à matrice à base d'Argent, dans lequel :
dans une étape monofilamentaire, on remplit une première enveloppe à base d'Argent, de réactifs poudreux susceptibles après traitement thermique de se transformer en matériau supraconducteur HTc;
on étire la billette résultante en un brin monofilamentaire ayant une forme carrée ou rectangulaire en coupe transversale;
dans une première étape multifilamentaire, on tronçonne ledit brin monofilamentaire et on remplit une enveloppe secondaire à base d'Argent de section carrée ou rectangulaire avec les tronçons résultants, réalisant ainsi une billette multifilamentaire, la billette multifilamentaire étant étirée à son tour en un brin multifilamentaire de section carrée ou rectangulaire;
dans une étape multifilamentaire secondaire, réalisées au moins une fois,
on tronçonne ledit brin multifilamentaire et on remplit une nouvelle enveloppe à base d'Argent de section carrée ou rectangulaire avec les tronçons résultants, réalisant ainsi une nouvelle billette multifilamentaire, la nouvelle billette multifilamentaire étant étirée à son tour en un nouveau brin multifilamentaire de section carrée ou rectangulaire;
on réalise une mise en forme du nouveau brin multifilamentaire;
on effectue un traitement thermique du brin mis en forme;
selon l'invention, on isole électriquement au plus deux faces de chaque tronçon de brin monofilamentaire, et
durant la première étape multifilamentaire on remplit l'enveloppe secondaire à base d'Argent de section carrée ou rectangulaire avec les tronçons résultants, réalisant ainsi la billette multifilamentaire.

Dans un mode de fabrication, on dépose une couche de matériau électriquement isolant sur les faces à isoler des tronçons de brin monofilamentaire.

Dans un autre mode de fabrication, lors de la réalisation de la billette multifilamentaire de la première étape multifilamentaire, on intercale un matériau électriquement isolant entre les faces à isoler des tronçons de brin monofilamentaire rangés dans l'enveloppe.

Selon une autre caractéristique du procédé selon l'invention, durant étape multifilamentaire secondaire, on isole au moins une des faces des tronçons de brin multifilamentaire, puis
on remplit l'enveloppe secondaire à base d'Argent de section carrée ou rectangulaire avec les tronçons résultants, réalisant ainsi la nouvelle billette multifilamentaire.

Dans un mode de réalisation on dépose une couche de matériau électriquement isolant sur les faces à isoler des tronçons de brin multifilamentaire.

Dans un autre mode de réalisation, lors de la réalisation de la billette multifilamentaire de l'étape multifilamentaire secondaire, on intercale un matériau électriquement isolant entre les faces à isolées des tronçons de brins multifilamentaires rangés dans l'enveloppe.

L'invention concerne aussi un brin multifilamentaire supraconducteur HTc selon la revendication 1 ayant en coupe transversale une forme générale carrée ou rectangulaire, comprenant une pluralité de filaments supraconducteurs, chaque filament supraconducteur ayant en coupe transversale une forme générale carrée ou rectangulaire, comprenant un coeur en céramique supraconductrice HTc, ledit coeur en céramique supraconductrice HTc étant entouré par une gaine d'Ag.

Selon l'invention, chaque filament supraconducteur comprend une couche d'isolant électrique sur au plus deux des faces de la gaine d'Ag.

Un premier avantage de la présente invention résulte des meilleures caractéristiques de découplage des filaments du fait de l'existence d'une couche d'isolant sur au plus deux faces de chaque filament.

Un autre avantage de la présente invention résulte de la réduction des coûts de fabrication d'un brin selon l'invention.

Un autre avantage de la présente invention résulte du fait que le procédé proposé par l'invention peut être mis en oeuvre sur les dispositifs de fabrication existants.

D'autres avantages et caractéristiques de la présente invention résulteront de la description qui va suivre en référence aux dessins annexés dans lesquels :
la figure 1 représente un organigramme d'une mise en oeuvre du procédé selon l'invention.
La figure 2 représente un organigramme d'une autre mise en oeuvre du procédé selon l'invention.
La figure 3 représente un organigramme d'une autre mise en oeuvre du procédé selon l'invention.

Dans la suite de la description, on appellera matériau électriquement isolant un matériau qui est électriquement isolant naturellement, ou un matériau qui devient isolant après les traitements mécaniques et/ou thermiques que le brin multifilamentaire subit dans le procédé selon l'invention.

Le procédé de fabrication du type poudre en tube d'un brin multifilamentaire supraconducteur HTc à matrice à base d'Argent selon l'invention comprend les étapes suivantes connues :
dans une étape monofilamentaire, on remplit une première enveloppe 1 à base d'Argent, de réactifs poudreux 2 susceptibles après traitement thermique de se transformer en matériau supraconducteur HTc;
on étire 90 la billette 3 résultante en un brin monofilamentaire 4 ayant une forme carrée ou rectangulaire en coupe transversale;
dans une première étape multifilamentaire 91, 92 on tronçonne ledit brin monofilamentaire et on remplit 91 une enveloppe secondaire 7 à base d'Argent de section carrée ou rectangulaire avec les tronçons résultants 8, 8', réalisant ainsi une billette multifilamentaire 6, la billette multifilamentaire 6 étant étirée 92 à son tour en un brin multifilamentaire 9 de section carrée ou rectangulaire;
dans une étape multifilamentaire secondaire 93, 99, réalisées au moins une fois,
on tronçonne ledit brin multifilamentaire 9 et on remplit 93 une nouvelle enveloppe (11) à base-d'Argent de section carrée ou rectangulaire avec les tronçons 12, 12' résultants, réalisant ainsi une nouvelle billette multifilamentaire 10, la nouvelle billette multifilamentaire 10 étant étirée 99 à son tour en un nouveau brin multifilamentaire de section carrée ou rectangulaire;
on réalise une mise en forme 100 du nouveau brin multifilamentaire;
on effectue un traitement thermiquement 101 du brin mis en forme.

L'étape de mise en forme 100 est par exemple une réduction aux dimensions voulues puis un torsadage du conducteur. l'étape de traitement thermique 101 a, par exemple, pour but de transformer les précurseurs en poudre en céramique supraconductrice HTc et à relâcher des contraintes dues aux différents traitements mécaniques subit par le conducteur.

le procédé selon l'invention introduit des étapes supplémentaires selon lesquelles on isole 95, 91' électriquement au plus deux faces 15 de chaque tronçon 8, 8' de brin monofilamentaire 4, et
durant la première étape multifilamentaire 91 on remplit l'enveloppe secondaire 7 à base d'Argent de section carrée ou rectangulaire avec les tronçons résultants 8, 8', réalisant ainsi la billette multifilamentaire 6 avec des tronçons de monofilament 8, 8' partiellement isolés les uns des autres.

Le brin multifilamentaire 9 résultant présente donc une pluralité de monofilaments 8, 8' ayant tous au plus deux faces 15 pourvue d'un matériau électriquement isolant 13, 14. Dans le mode de réalisation représenté sur les figures, seule une face 15 du brin monofilamentaire 4 est isolée. Les tronçons 8, 8' sont alors rangés de telle manière que deux couches adjacentes de tronçons 8, 8' sont isolées l'une de l'autre.

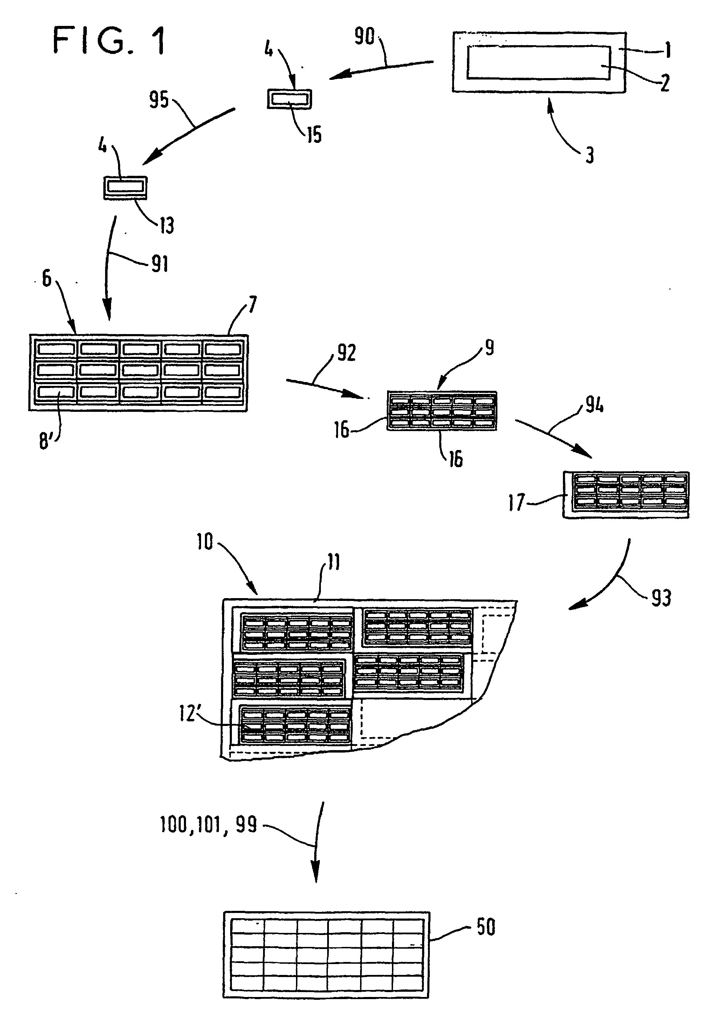

Dans la mise en oeuvre représentée sur la figure 1, on dépose 95 une couche de matériau électriquement isolant 13 sur une seule face 15 à isoler du brin monofilamentaire 4. Toute méthode adéquate de dépôt de couche mince peut être utilisée.

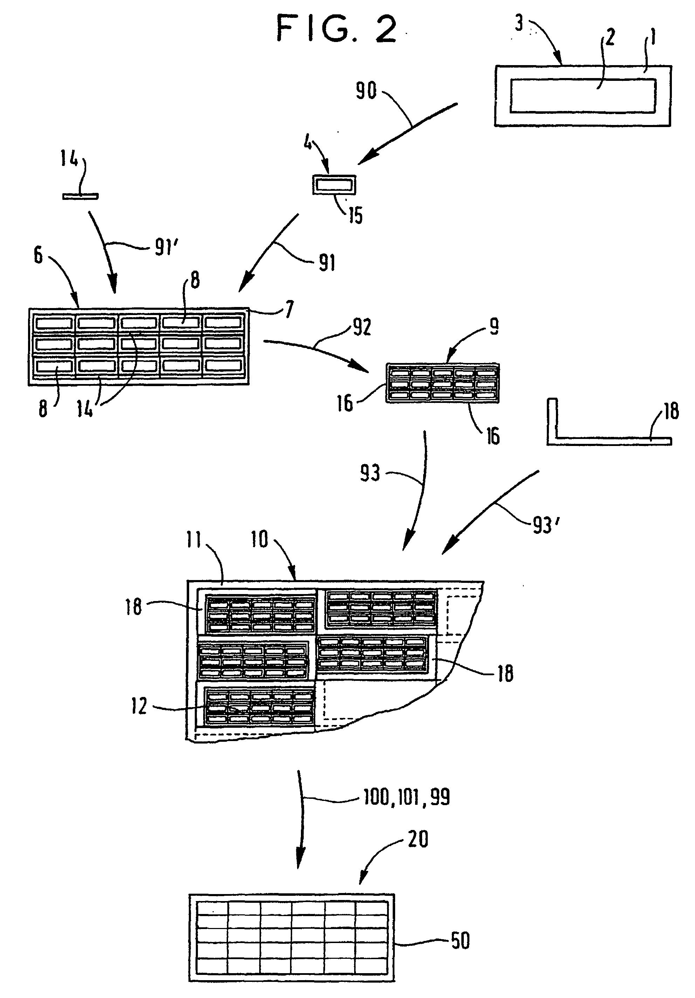

Dans la mise en oeuvre représentée sur la figure 2, lors de la réalisation 91 de la billette multifilamentaire 6 de la première étape multifilamentaire, on intercale 91' un matériau électriquement isolant 14 entre les faces 15 à isolées des tronçons de brin monofilamentaire rangés dans l'enveloppe 7. Le matériau isolant peut être sous forme de plaque intercalée entre chaque couche de monofilament.

Une autre caractéristique du présent procédé résulte des étapes supplémentaires dans lesquelles :
durant l'étape multifilamentaire secondaire 93, 99, on isole 93', 94 au moins une des faces 16 des tronçons 12, 12' de brin multifilamentaire 9, puis
on remplit l'enveloppe 11 secondaire à base d'Argent de section carrée ou rectangulaire avec les tronçons résultants 12, 12', réalisant ainsi la nouvelle billette multifilamentaire.

Le nouveau brin multifilamentaire présente donc une pluralité de brins multifilamentaires 12, 12' ayant tous au moins une face 16 pourvue d'un matériau électriquement isolant 17, 18.

Dans le mode de réalisation représenté sur les figures, deux faces adjacentes 16 du brin multifilamentaire 9 sont isolées. Les tronçons 12, 12' sont alors rangés de telle manière que chaque tronçon multifilamentaire est isolé des tronçons multifilamentaires qui l'entourent.

Dans la mise en oeuvre représentée sur la figure 1 on dépose 94 une couche de matériau électriquement isolant 17 sur les faces 16 à isolées des tronçons 12' de brin multifilamentaire 9.

Dans la mise en oeuvre représentée sur la figure 2, lors de la réalisation 93 de la billette multifilamentaire 10 de l'étape multifilamentaire secondaire, on intercale 93' un matériau électriquement isolant 18 entre les faces 16 à isolées des tronçons 12 de brin multifilamentaire 9 rangés dans l'enveloppe 11. La forme du matériau électriquement isolant 18 intercalé peut être autre qu'en "L". Par exemple, le matériau électriquement isolant intercalé peut avoir une forme en croix et réaliser l'isolation de quatre tronçons multifilamentaires ayant un coin commun.

La transformation des précurseurs en phase supraconductrice nécessite la présence d'oxygène. C'est aussi un but de la présente invention de proposer un brin multifilamentaire supraconducteur HTc présentant un compromis optimisé entre le découplage des filaments et la perméabilité à l'oxygène pour la transformation en phase supraconductrice HTc.

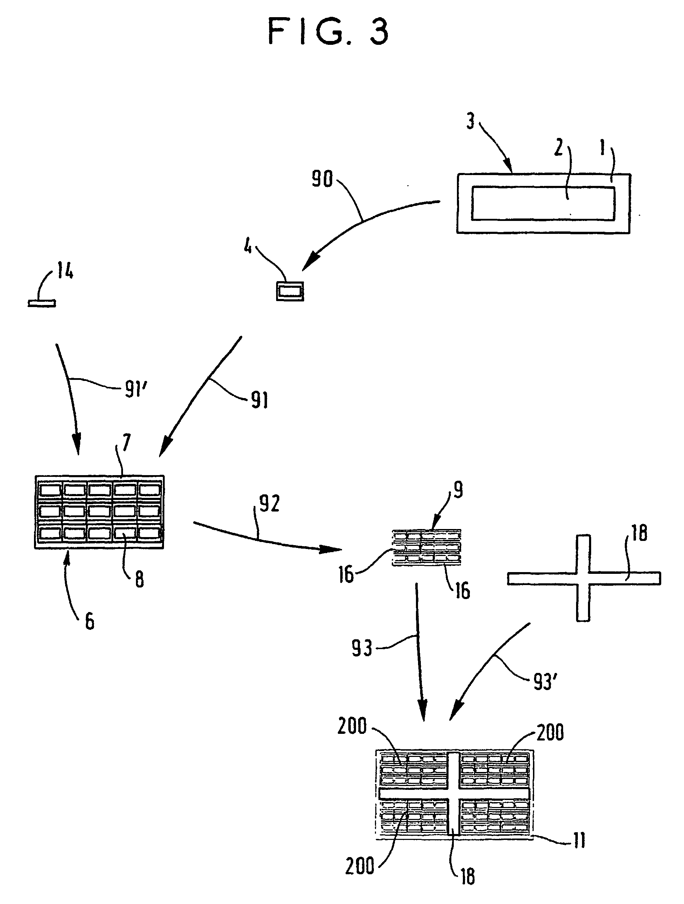

A cet effet l'invention propose d'appliquer le procédé selon l'invention avec seulement quatre tronçons 200 de brin multifilamentaire 9 dans une, seule étape multifilamentaire secondaire. Ainsi, les tronçons 200 sont bien isolés les uns des autres tout en présentant une surface conséquente sans barrière isolante au contact de l'enveloppe en Ag. C'est à travers cette enveloppe 11 que se fait le passage de l'oxygène vers les quatre tronçons multifilamentaires 200. En outre, du fait de la disposition de la barrière isolante sur une face seulement des filaments, l'oxygène peut aisément atteindre les précurseurs au coeur de chaque filament en passant à travers la paroi en Ag non pourvue de barrière isolante (Cf figure 3)

L'invention concerne aussi un brin multifilamentaire supraconducteur HTc ayant en coupe transversale une forme générale carrée ou rectangulaire, comprenant une pluralité de filaments supraconducteurs, chaque filament supraconducteur ayant en coupe transversale une forme générale carrée ou rectangulaire, comprenant un coeur en céramique supraconductrice HTc, ledit coeur en céramique supraconductrice HTc étant entouré par une gaine d'Ag.

Selon l'invention, chaque filament supraconducteur comprend une couche d'isolant électrique sur au plus deux des faces de la gaine d'Ag.

## Revendications

1. Brin multifilamentaire supraconducteur HTc ayant en coupe transversale une forme générale carrée ou rectangulaire, comprenant une pluralité de filaments supraconducteurs, chaque filament supraconducteur ayant en coupe transversale une forme générale carrée ou rectangulaire, comprenant un coeur en céramique supraconductrice HTc, ledit coeur en céramique supraconductrice HTc étant entouré par une gaine d'Ag,
le brin étant **caractérisé en ce que** chaque filament supraconducteur comprend une couche d'isolant électrique (13,14) sur au plus deux des faces de la gaine d'Ag.

2. Procédé de fabrication du type poudre en tube d'un brin multifilamentaire supraconducteur HTc à matrice à base d'Argent selon la revendication 1 dans lequel :
dans une étape monofilamentaire, on remplit une première enveloppe (1) à base d'Argent, de réactifs poudreux (2) susceptibles après traitement thermique de se transformer en matériau supraconducteur HTc;
on étire (90) la billette (3) résultante en un brin monofilamentaire (4) ayant une forme carrée ou rectangulaire en coupe transversale;
dans une première étape multifilamentaire (91, 92), on tronçonne ledit brin monofilamentaire (4) et on remplit (91) une enveloppe secondaire (7) à base d'Argent de section carrée ou rectangulaire avec les tronçons résultants( 8, 8'), réalisant ainsi une billette multifilamentaire (6), la billette multifilamentaire (6) étant étirée (92) à son tour en un brin multifilamentaire (9) de section carrée ou rectangulaire;
dans une étape multifilamentaire secondaire (93, 99), réalisées au moins une fois,
on tronçonne ledit brin multifilamentaire (9) et on remplit (93) une nouvelle enveloppe 11 à base d'Argent de section carrée ou rectangulaire avec les tronçons résultants (12, 12'), réalisant ainsi une nouvelle billette multifilamentaire, la nouvelle billette multifilamentaire étant étirée (99) à son tour en un nouveau brin multifilamentaire (50) de section carrée ou rectangulaire;
on réalise une mise en forme (100) du nouveau brin multifilamentaire (50);
on effectue un traitement thermiquement (101) du brin mis en forme;
le procédé étant **caractérisé en ce qu'**on isole (91', 95) électriquement au plus deux faces (15) du brin monofilamentaire (4), et
durant la première étape multifilamentaire (91, 92) on remplit (91) l'enveloppe secondaire (7) à base d'Argent de section carrée ou rectangulaire avec les tronçons résultants (8, 8'), réalisant ainsi la billette multifilamentaire (6).

3. Procédé de fabrication selon la revendication 2 **caractérisé en ce qu'**on dépose (95) une couche de matériau électriquement isolant (13) sur les faces (15) à isoler des tronçons (8') de brin monofilamentaire (4).

4. Procédé de fabrication selon la revendication 2 **caractérisé en ce que** lors de la réalisation (91) de la billette multifilamentaire (6) de la première étape multifilamentaire, on intercale (91') un matériau électriquement isolant (14) entre les faces (15) à isoler des tronçons (8) de brin monofilamentaire (4) rangés dans l'enveloppe.

5. Procédé de fabrication selon l'une quelconque des revendications 2 à 4 **caractérisé en ce que** durant étape multifilamentaire secondaire (93, 99), on isole (93', 94) au moins une (16) des faces du brin multifilamentaire (9), et
on remplit (93) la nouvelle enveloppe (11) à base d'Argent de section carrée ou rectangulaire avec les tronçons (12, 12') résultants, réalisant ainsi la nouvelle billette multifilamentaire (10).

6. procédé de fabrication selon la revendication 5 **caractérisé en ce qu'**on dépose (94) une couche de matériau électriquement isolant (17) sur les faces (16) à isoler des tronçons (12') de brin multifilamentaire (9).

7. Procédé de fabrication selon la revendication 5 ou 6 **caractérisé en ce que**, lors de la réalisation (93) de la billette multifilamentaire (10) de l'étape multifilamentaire secondaire, on intercale (93') un matériau électriquement isolant (18) entre les faces (16) à isoler des tronçons (12) de brin multifilamentaire (9) rangés dans l'enveloppe (11).

## Patentansprüche

1. HTc-supraleitender mehrfaseriger Strang mit einer im Querschnitt allgemein rechteckigen oder rechtwinkligen Form, welcher eine Vielzahl von supraleitenden Fasern umfasst, wobei jede supraleitende Faser im Querschnitt eine allgemein rechteckige oder rechtwinklige Form hat, einen Kern aus HTC-supraleitender Keramik hat, und der Kern aus HTC-supraleitender Keramik von einer Hülle aus Ag umgeben ist, wobei der Strang **dadurch gekennzeichnet ist, dass** jede supraleitende Faser auf höchstens zwei der Seiten der Hülle aus Ag eine elektrisch isolierende Schicht (13, 14) aufweist.

2. Verfahren zur Herstellung vom Typ Pulver im Rohr eines HTc-supraleitenden mehrfaserigen Strangs mit einer Matrix auf Basis von Silber nach Anspruch 1, mit den folgenden Schritten:
- in einem einfaserigen Schritt füllt man eine erste Hülle (1) auf Basis von Silber mit pulverigen Reagenzien (2), welche geeignet sind, sich nach eine thermischen Behandlung in ein HTc-supraleitendes Material umzuwandeln;
- man zieht (90) den sich ergebenden Bolzen (3) in einen einfaserigen Strang (4), welcher im Querschnitt eine rechteckige oder rechtwinklige Form hat;
- in einem ersten mehrfaserigen Schritt (91, 92) längt man den einfaserigen Strang (4) ab und man füllt (91) eine zweite Hülle (7) auf Basis von Silber von rechteckigem oder rechwinkligem Querschnitt mit den sich ergebenden Abschnitten (8, 8'), wodurch ein mehrfaseriger Bolzen (6) entsteht, wobei der mehrfaserige Bolzen (6) seinerseits in einen mehrfaserigen Strang (9) von rechteckigem oder rechtwinkligem Querschnitt gezogen (92) wird;
- in einem zweiten mehrfaserigen Schritt (93, 99), welcher wenigstens einmal durchgeführt wird,
- längt man den mehrfaserigen Strang (9) ab und man füllt (93) eine neue Hülle (11) auf Basis von Silber von rechteckigem oder rechtwinkligem Querschnitt mit den sich ergebenden Abschnitten (12, 12'), wodurch ein neuer mehrfaseriger Bolzen entsteht, wobei der neue mehrfaserige Bolzen seinerseits in einen neuen mehrfaserigen Strang (50) von rechteckigem oder rechtwinkligem Querschnitt gezogen (99) wird;
- man unterzieht den neuen mehrfaserigen Strang (50) einer Formung (100);
- man führt eine thermische Behandlung (101) des geformten Strangs durch;
wobei das Verfahren **dadurch gekennzeichnet ist, dass**
- man höchstens zwei Seiten (15) des mehrfaserigen Strangs (4) elektrisch isoliert (91', 95), und
- während des ersten mehrfaserigen Schritts (91, 92) die zweite Hülle (7) auf Basis von Silber von rechteckigem oder rechtwinkligem Querschnitt mit den sich ergebenden Abschnitten (8, 8') gefüllt wird, wodurch der mehrfaserige Bolzen (6) entsteht.

3. Herstellungsverfahren nach Anspruch 2, **dadurch gekennzeichnet, dass** man eine Schicht aus elektrisch isolierendem Material (13) auf die zu isolierenden Seiten (15) der Abschnitte (8') des einfaserigen Strangs (4) abscheidet (95).

4. Herstellungsverfahren nach Anspruch 2, **dadurch gekennzeichnet, dass** man bei der Herstellung (91) des mehrfaserigen Bolzens (6) des ersten mehrfaserigen Schritts ein elektrisch isolierendes Material (14) zwischen die zu isolierenden Seiten (15) der in der Hülle angeordneten Abschnitte (8) des einfaserigen Strangs (4) einfügt (91').

5. Herstellungsverfahren nach einem der Ansprüche 2 bis 4, **dadurch gekennzeichnet, dass** man während des zweiten mehrfaserigen Schritts (93, 99) wenigstens eine (16) der Seiten des mehrfaserigen Strangs (9) isoliert (93', 94), und dass man die neue Hülle (11) auf Basis von Silber von rechteckigem oder rechtwinkligem Querschnitt mit den sich ergebenden Abschnitten (12, 12') füllt (93), wodurch der neue mehrfaserige Bolzen (10) entsteht.

6. Herstellungsverfahren nach Anspruch 5, **dadurch gekennzeichnet, dass** man eine Schicht aus elektrisch isolierendem Material (17) auf die zu isolierenden Seiten (16) der Abschnitte (12') des mehrfaserigen Strangs (9) abscheidet (94).

7. Herstellungsverfahren nach Anspruch 5 oder 6, **dadurch gekennzeichnet, dass** man bei der Herstellung (93) des mehrfaserigen Bolzens (10) des zweiten mehrfaserigen Schritts ein elektrisch isolierendes Material (18) zwischen die zu isolierenden Seiten (16) der in der Hülle (11) angeordneten Abschnitte (12) des mehrfaserigen Strangs (9) einfügt.

## Claims

1. An HTc superconductive multifilament strand having a cross-section that is generally square or rectangular in shape, comprising a plurality of superconductive filaments, each superconductive filament having a cross-section that is generally square or rectangular in shape, comprising a core of HTc superconductive ceramic, said HTc superconductive ceramic core being surrounded by Ag cladding,
the strand being **characterized in that** each superconductive filament includes an electrically insulating layer (13, 14) on, at most, two faces of its Ag cladding.

2. A powder in tube type method of making an HTc superconductive multifilament strand with a silver-based matrix and as defined in claim 1, in which:
in a monofilament step, a first silver-based envelope (1) is filled with powder reagents (2) suitable, after heat treatment, for transforming into an HTc superconductive material;
the resulting billet (3) is drawn down (90) into a monofilament strand (4) with a cross-section that is square or rectangular in shape;
in a first multifilament step (91, 92) said monofilament strand (4) is cut into lengths and a secondary silver-based envelope (7) of square or rectangular section is filled (91) with the resulting lengths (8, 8'), thereby making a multifilament billet (6), the multifilament billet (6) being drawn down (92) in turn to form a multifilament strand (9) of square or rectangular section;
in a secondary multifilament step (93, 99), that is performed at least once, said multifilament strand (9) is cut up into lengths and a new silver-based envelope (11) of square or rectangular section is filled (93) with the resulting lengths (12, 12'), thereby making a new multifilament billet, the new multifilament billet being drawn down (99) in turn to form a new multifilament strand (50) of square or rectangular section;
the new multifilament strand (50) is shaped (100); and
heat treatment (101) is applied to the shaped strand;
the method being **characterized in that**, at most, two faces (15) of the monofilament strand (4) are electrically insulated (91', 95); and
during the first multifilament step (91, 92) the silver-based secondary envelope (7) of square or rectangular section is filled (91) with the resulting lengths (8, 8'), thereby making the multifilament billet (6).

3. A method according to claim 2, **characterized in that** a layer of electrically insulating material (13) is deposited (95) on the faces (15) to be insulated of the lengths (8') of the monofilament strand (4).

4. A method according to claim 2, **characterized in that** while making (91) the multifilament billet (6) of the first multifilament step, an electrically insulating material (14) is interposed (91') between the faces (15) to be insulated of the lengths (8) of monofilament strand (4) placed in the envelope.

5. A method according to any one of claims 2 to 4, **characterized in that** during a secondary multifilament step (93, 99) at least one (16) of the faces of the multifilament strand (9) is insulated (93', 94); and
the new silver-based envelope (11) of square or rectangular section is filled (93) with the resulting lengths (12, 12'), thereby making a new multifilament billet (10).

6. A method according to claim 5, **characterized in that** a layer of electrically insulating material (17) is deposited (94) on the faces (16) to be insulated of the lengths (12') of the multifilament strand (9).

7. A method according to claim 5 or 6, **characterized in that**, while making (93) the multifilament billet (10) of the secondary multifilament step, an electrically insulating material (18) is interposed (93') between the faces (16) to be insulated of the lengths (12) of multifilament strand (9) placed in the envelope (11).
